# EUROPÄISCHE PATENTSCHRIFT

(11) **EP 1 145 319 B1**
(45) Veröffentlichungstag und Bekanntmachung des Hinweises auf die Patenterteilung: **10.05.2006**
(21) Anmeldenummer: 99966816.3
(22) Anmeldetag: 01.12.1999
(51) Int. Cl.: H01L 27/108, H01L 21/8242

(54) **INTEGRIERTE SCHALTUNGSANORDNUNG UND VERFAHREN ZU DEREN HERSTELLUNG**
INTEGRATED CIRCUIT AND METHOD FOR THE PRODUCTION THEREOF
CIRCUIT INTEGRE ET SON PROCEDE DE FABRICATION

(30) Priorität: 03.12.1998 DE 19855878
(43) Veröffentlichungstag der Anmeldung: 17.10.2001
(73) Patentinhaber: Infineon Technologies AG, 81669 München (DE)
(72) Erfinder: KRAUTSCHNEIDER, Wolfgang, D-21149 Hamburg (DE); SCHLÖSSER, Till, D-01109 Dresden (DE); HOFMANN, Franz, D-80995 München (DE); WILLER, Josef, D-85521 Riemerling (DE)
(74) Vertreter: Kottmann, Heinz Dieter
(86) Internationale Anmeldenummer: PCT/DE1999/003828
(87) Internationale Veröffentlichungsnummer: WO 2000/033382

(56) Entgegenhaltungen:
- US-A- 5 463 234
- US-A- 5 710 072
- US-A- 5 710 448
- KRAUTSCHNEIDER W H ET AL: "PLANAR GAIN CELL FOR LOW VOLTAGE OPERATION AND GIGABIT MEMORIES" SYMPOSIUM ON VLSI TECHNOLOGY,US,NEW YORK, IEEE, Bd. SYMP. 15, 1995, Seiten 139-140, XP000580856 ISBN: 0-7803-2603-2

## Beschreibung

Die Erfindung betrifft eine integrierte Schaltungsanordnung und ein Verfahren zu deren Herstellung.

Es wird allgemein erstrebt, eine integrierte Schaltungsanordnung, d. h. eine Schaltung, die in einem Substrat integriert ist, mit immer höherer Packungsdichte zu erzeugen.

In DE 197 27 436 C1 wird eine DRAM-Zellenanordnung beschrieben, bei der eine Speicherzelle einen ersten Transistor, eine Diodenstruktur und einen zweiten Transistor umfaßt. Der erste Transistor und der zweite Transistor teilen sich ein gemeinsames Source/Drain-Gebiet und sind zwischen einen Spannungsanschluß und eine Bitleitung geschaltet. Eine Gateelektrode des zweiten Transistors ist mit einer Wortleitung verbunden. Die Diodenstruktur ist zwischen die Gateelektrode des ersten Transistors und das gemeinsame Source/Drain-Gebiet geschaltet. Die Transistoren sind übereinander angeordnet und als vertikale MOS-Transistoren ausgebildet. Das gemeinsame Source/Drain-Gebiet ist in einer Halbleiterstruktur angeordnet, an deren Flanken Gateelektroden der Transistoren in Form von Spacern angeordnet sind. Die Diodenstruktur besteht aus einer Schottkydiode und einer Tunneldiode, die in Reihe geschaltet sind. Die Tunneldiode wird durch die Gateelektrode des ersten Transistors, eine dielektrische Schicht, die auf der Gateelektrode des ersten Transistors angeordnet ist, und durch einen weiteren leitenden Spacer, der durch die dielektrische Schicht von der Gateelektrode des ersten Transistors getrennt ist, gebildet. Die Schottkydiode wird durch eine leitfähige Struktur aus Metallsilizid, die auf einem oberen Teil des weiteren leitenden Spacers angeordnet ist und an das gemeinsame Source/Drain-Gebiet angrenzt, und den leitenden Spacer gebildet.

In der EP 0 537 203 wird eine DRAM-Zellenanordnung beschrieben, bei der eine Speicherzelle einen planaren ersten Transistor, einen planaren zweiten Transistor und einen spannungsabhängigen Widerstand umfaßt. Der erste Transistor und der zweite Transistor weisen ein gemeinsames Source/Drain-Gebiet auf und sind zwischen einen Spannungsanschluß und eine Bitleitung geschaltet. Eine Gateelektrode des ersten Transistors ist über einem Gatedielektrikum und einem Metallfilm, der über dem gemeinsamen Source/Drain-Gebiet angeordnet ist, angeordnet. Das gemeinsame Source/Drain-Gebiet ist über den spannungsabhängigen Widerstand mit der Gateelektrode des ersten Transistors verbunden. Der spannungsabhängige Widerstand ist z. B. ein Schottky-Übergang und wird durch die Gateelektrode des ersten Transistors und den Metallfilm gebildet. Eine Gateelektrode des zweiten Transistors ist mit einer Wortleitung verbunden. Der spannungsabhängige Widerstand erfordert keinen zusätzlichen Platzbedarf, was zur Erhöähung der Packungsdichte der DRAM-Zellenanordnung beiträgt.

Aus der US 5,463,234 ist eine integrierte Schaltungsanordnung bekannt, bei der eine Schottky-Diode zwischen Source/Drain und einem Titanfilm liegt, der sich über eine Gateelektrode erstreckt. Zwischen der Gateelektrode und dem Titanfilm befinden sich ein Siliziumfilm und ein Titansilizidfilm. Dieser Titansilizidfilm bildet auf Source/Drain die Schottky-Diode, die gegebenenfalls durch eine Diode mit pn-Übergangsstruktur ersetzt werden kann.

Weiterhin ist es aus der US 5,710,448 bekannt, einen Diodenkontakt so zu realisieren, dass ein Sperrstrom auf Grund von Tunnelprozessen fließt.

Der Erfindung liegt die Aufgabe zugrunde, eine weitere integrierte Schaltungsanordnung anzugeben, die eine DRAM-Zellenanordnung mit hoher Packungsdichte umfassen kann; ferner soll ein Verfahren zur Herstellung einer solchen integrierten Schaltungsanordnung angegeben werden.

Diese Aufgabe wird erfindungsgemäß durch eine integrierte Schaltungsanordnung mit den Merkmalen des Patentanspruches 1 bzw. durch ein Verfahren mit den Merkmalen des Patentanspruches 10 gelöst. Vorteilhafte Weiterbildungen der Erfindung ergeben sich aus den Unteransprüchen.

Eine integrierte Schaltungsanordnung umfaßt einen planaren ersten Transistor, dessen erstes Source/Drain-Gebiet und dessen zweites Source/Drain-Gebiet in einem Substrat angeornet sind und an eine Hauptfläche des Substrats angrenzen. Eine Gateelektrode des ersten Transistors ist über dem Substrat vorgesehen. Eine Diode ist so zwischen das erste Source/Drain-Gebiet und die Gateelektrode geschaltet, daß ein Abfließen von Ladung von der Gateelektrode zum ersten Soruce/Drain-Gebiet erschwert wird. Eine Diodenschicht, die Teil der Diode ist, ist auf mindestens einem Teil des ersten Source/Drain-Gebietes angeordnet.

Eine leitende Struktur, die ein weiterer Teil der Diode ist, ist über mindestens einem Teil der Gateelektrode und auf der Diodenschicht angeordnet.

Bei einem Verfahren zur Herstellung einer integrierten Schaltungsanordnung werden durch maskierte Implantation eines Substrats ein erstes Source/Drain-Gebiet und ein zweites Source/Drain-Gebiet eines planaren ersten Transistors erzeugt, so daß sie an eine Hauptfläche des Substrats angrenzen. Über dem Substrat wird eine Gateelektrode des ersten Transistors erzeugt. Eine Diodenschicht, die Teil einer Diode ist, wird auf mindestens einem Teil des ersten Source/Drain-Gebiets erzeugt. Eine leitende Struktur, die ein weiterer Teil der Diode ist, wird so erzeugt, da sie über mindestens einem Teil der Gateelektrode und auf der Diodenschicht angeordnet ist. Die Diode wird so erzeugt, daß ein Abfließen von Ladung von der Gateelektrode zum ersten Source/Drain-Gebiet erschwert wird.

Da die Diode über dem ersten Transistor angeordnet ist, kann die integrierte Schaltungsanordnung eine hohe Packungsdichte aufweisen. Im Gegensatz zur EP 0 537 203 kann der erste Transistor wie ein Transistor in der derzeit üblichen Halbleiterfertigung hergestellt werden. Erst durch nachfolge Prozeßschritte wird die Diode hergestellt. Der Schottkyübergang gemäß EP 0 537 203 muß teilweise vor der Fertigstellung des Transistors erzeugt werden, da der Metallfilm unter der Gateelektrode angeordnet ist. Außerdem können die Source/Drain-Gebiete des Transistors gemäß EP 0 537 203 nicht wie im herkömmlichen Verfahren nach Erzeugung der Gateelektrode durch Implantation erzeugt werden, da die Gateelektrode über einem größeren Teil des ersten Source/Drain-Gebiets angeordnet ist, auf dem der Metallfilm liegt. Ein weiterer Unterschied zur EP 0 537 203 besteht darin, daß die Gateelektrode des ersten Transistorys nicht Teil der Diode ist, so daß aufgrund der freien Wahl des Materials der leitenden Struktur elektrische Eigenschaften der Diode unabhängig von der Gateelektrode optimiert werden können.

Umfaßt die integrierte Schaltungsanordnung zusätzlich zum ersten Transistor und der Diode einen zweiten Transistor, dessen erstes Source/Drain-Gebiet mit dem ersten Source/Drain-Gebiet des ersten Transistors verbunden ist, so kann die integrierte Schaltungsanordnung eine DRAM-Zellenanordnung umfassen. Der erste Transistor, die Diode und der zweite Transistor sind Teile einer Speicherzelle der DRAM-Zellenanordnung. Der erste Transistor und der zweite Transistor sind zwischen einen Spannungsanschluß und eine Bitleitung geschaltet. Eine Gateelektrode des zweiten Transistors ist mit einer Wortleitung verbunden. Die DRAM-Zellenanordnung ist in diesem Fall eine dynamische selbstverstärkende Speicherzellenanordnung.

Das Speichern einer logischen 1 in der Speicherzelle kann beispielsweise folgendermaßen durchgeführt werden: An die Bitleitung und an die Wortleitung der Speicherzelle wird eine Spannung angelegt, so daß Ladung über die Diode auf die Gateelektrode des ersten Transistors fließt.

Zum Speichern einer logischen 0 in der Speicherzelle wird an die Wortleitung eine Spannung angelegt, an die Bitleitung jedoch nicht, so daß kein Strom über die Diode auf die Gateelektrode des ersten Transistors fließt.

Zum Auslesen der Information wird an die Wortleitung und an die Bitleitung eine Spannung angelegt und geprüft, ob ein Strom durch die Bitleitung fließt oder nicht. Ist in der Speicherzelle die logische 1 gespeichert, so ist aufgrund der Ladung auf der Gateelektrode des ersten Transistors der erste Transistor eingeschaltet, so daß ein Strom vom Spannungsanschluß zu den Transistoren und durch die Bitleitung fließen kann. Die Ladung wird beim Auslesen auf der Gateelektrode des ersten Transistors gehalten, da die Diode so gepolt ist, daß die Ladung über die Diode nur erschwert abfließen kann. Ist in der Speicherzelle die logische 0 gespeichert, so fließt durch die Bitleitung kein Strom, da der erste Transistor aufgrund fehlender Ladung auf seiner Gateelektrode gesperrt ist.

Umfaßt die integrierte Schaltungsanordnung eine DRAM-Zellenanordnung, so ist es zur Verkleinerung des Prozeßaufwands vorteilhaft, wenn der zweite Transistor ebenfalls planar ist. Die Source/Drain-Gebiete und die Gateelektroden der Transistoren können dann gleichzeitig erzeugt werden. Zur Erhöhung der Packungsdichte ist es besonders vorteilhaft, wenn das erste Source/Drain-Gebiet des ersten Transistors und das erste Source/Drain-Gebiet des zweiten Transistors als gemeinsames Source/Drain-Gebiet ausgestaltet sind. Die Gateelektrode des zweiten Transistors kann Teil der Wortleitung sein.

Die Diodenschicht kann z.B. leitendes Material enthalten, so daß die Diode eine Schottkydiode ist.

Damit der Stromfluß durch die Diode von der Temperatur unabhängig ist, ist es vorteilhaft, wenn die Diode als Tunneldiode ausgestaltet ist. Dazu enthält die Diodenschicht isolierendes Material. Die Dicke der Diodenschicht ist dabei so bemessen, daß ein Strom durch die Diodenschicht im wesentlichen aufgrund von Tunneln von Elektronen durch die Diodenschicht entsteht. Die Diodenschicht besteht beispielsweise aus SiO₂ und ist vorzugsweise dünner als 3 nm. Das SiO₂ kann abgeschieden werden oder durch thermische Oxidation aufgewachsen werden. Die Diodenschicht kann Nitrid oder Siliziumnitrid enthalten. Die Diodenschicht kann auch mehrere Teilschichten umfassen. Die Diode wird durch das erste Source/Drain-Gebiet des ersten Transistors, die Diodenschicht und die leitende Struktur gebildet. Im Gegensatz zur Diodenstruktur der DRAM-Zellenanordnung gemäß DE 197 27 436 C1 umfaßt die Diode nur drei Elemente und ist mit einem geringeren Prozeßaufwand herstellbar.

Eine Möglichkeit die Diode so zu polen, daß ein Stromfluß von der Gateelektrode des ersten Transistors zum ersten Source/Drain-Gebiet des ersten Transistors erschwert wird, besteht darin, eine kleinere Dotierstoffkonzentration für die leitende Struktur als für das erste Source/Drain-Gebiet des ersten Transistors vorzusehen, wobei die leitende Struktur und das erste Source/Drain-Gebiet des ersten Transistors denselben Leitfähigkeitstyp aufweisen.

Damit die Diodenschicht besonders gleichmäßig und dünn ist, kann sie durch Rapid Thermal Nitridation (RTN) bei ca. 1000°C mit NH₃ aufgewachsen werden. Der Prozeß begrenzt sich schon bei geringen Dicken selbst, d.h. die bereits aufgewachsene Diodenschicht verhindert eine weitere Diffusion von Atomen zur Hauptfläche des Substrats.

Bei der Erzeugung der Diodenschicht kann zunächst eine weitere Schicht auf der Gateelektrode erzeugt werden. Die Diodenschicht kann z.B. durch thermische Oxidation erzeugt werden, so daß auf der Gateelektrode die weitere Schicht erzeugt wird. Anschließend wird die weitere Schicht durch einen maskierten Ätzprozeß entfernt.

Um bei der Erzeugung der Diodenschicht zu verhindern, das dabei die weitere Schicht auf der Gateelektrode erzeugt wird, kann vor Erzeugung der Diodenschicht eine schützende Struktur auf der Gateelektrode erzeugt werden. Die schützende Struktur wird nach Erzeugung der Diodenschicht entfernt.

Vorzugsweise weist die Gateelektrode eine rauhere Oberfläche auf als das erste Source/Drain-Gebiet. Beispielsweise kann die Gateelektrode aus dotiertem Polysilizium erzeugt werden, und das Substrat kann mindestens im Bereich des ersten Source/Drain-Gebiets monokristallines Silizium enthalten. Wird die Diodenschicht z.B. durch thermische Oxidation erzeugt, so wird auf der Gateelektrode die weitere Schicht erzeugt, die aufgrund der rauhen Oberfläche der Gateelektrode inhomogen wächst. Der Widerstand der weiteren Schicht ist im Vergleich zum Widerstand der Diodenschicht vernachlässigbar, da die weitere Schicht aufgrund seiner Inhomogenität einen deutlich höheren Stromfluß zuläßt als die Diodenschicht. Die leitende Struktur wird auf der Diodenschicht und auf der weiteren Schicht erzeugt. Elektrische Widerstände der Diode sind wesentlich größer als elektrische Widerstände, die durch die Gateelektrode, die weitere Schicht und die leitende Struktur gebildet werden. Ein Entfernen der weiteren Schicht oder die Erzeugung der schützenden Struktur, die die Gateelektrode vor der thermischen Oxidation schützt und die anschließend wieder entfernt wird, ist nicht erforderlich, so daß der Prozeßaufwand verkleinert wird.

Das Substrat kann ein anderes Halbleitermaterial, wie z.B. Germanium, enthalten.

Die Diodenschicht und die weitere Schicht können als Teile von isolierendem Material erzeugt werden, das im wesentlichen ganzflächig, z.B. durch unmaskierte thermische Oxidation, aufgebracht wird. Zur Erzeugung der leitenden Struktur kann leitendes Material abgeschieden und strukturiert werden, wobei das isolierende Material als Ätzstop dient. Alternativ wird das leitende Material zusammen mit dem isolierenden Material strukturiert. In beiden Fällen ist zur Erzeugung der Diode nur eine Maske erforderlich, nämlich die zur Strukturierung der leitenden Struktur.

Es liegt im Rahmen der Erfindung, wenn nach Erzeugung des ersten Transistors eine untere isolierende Schicht über dem Transistor abgeschieden wird. In der unteren Schicht kann eine Vertiefung erzeugt werden, so daß mindestens ein Teil der Gateelektrode und des ersten Source/Drain-Gebiets freigelegt werden. Anschließend können die Diodenschicht und die weitere Schicht erzeugt werden, indem z. B. eine thermische Oxidation durchgeführt wird. Anschließend kann leitendes Material abgeschieden werden. Seitlich außerhalb der Vertiefung befindliche Teile des leitenden Materials werden entfernt, so daß aus dem leitenden Material die leitende Struktur erzeugt wird. Zur Erzeugung der Diode ist auch hier nur eine Maske erforderlich, nämlich die zur Erzeugung der Vertiefung.

Im folgenden bezeichnet "Höhe" einen Abstand von der Hauptfläche des Substrats längs einer Achse, die senkrecht zur Hauptfläche verläuft.

Beim Abscheiden des leitenden Materials kann die Vertiefung gefüllt werden. Das leitende Material außerhalb der Vertiefung kann durch chemisch-mechanisches Polieren entfernt werden. Es liegt im Rahmen der Erfindung, wenn anschließend durch Rückätzen des leitenden Materials eine Höhe der leitenden Struktur verkleinert wird. Das leitende Material kann auch so abgeschieden werden, daß Flächen der Vertiefung bedeckt werden, die Vertiefung aber nicht gefüllt wird. Leitendes Material außerhalb der Vertiefung kann durch chemisch-mechanisches Polieren entfernt werden.

Um den Widerstand der weiteren Schicht zu verkleinern, ist es vorteilhaft, wenn eine Fläche der weiteren Schicht mehr als ca. zwei mal größer ist als eine Fläche der Diodenschicht.

Es liegt im Rahmen der Erfindung, wenn über dem Substrat ein Kondensator angeordnet ist, dessen erste Kondensatorelektrode mit der leitenden Struktur elektrisch verbunden ist. Ein erster Teil der ersten Kondensatorelektrode ist auf einem Rand einer Projektion der ersten Kondensatorelektrode auf die Hauptfläche des Substrats angeordnet. Der erste Teil der ersten Kondensatorelektrode reicht bis zu einer Höhe, die größer ist als eine Höhe, bis zu der ein zweiter Teil der ersten Kondensatorelektrode reicht, der auf übrigen Teilen der Projektion angeordnet ist. Die erste Kondensatorelektrode weist folglich innere Flanken und äußere, der Projektion abgewandte Flanken auf. Näherungsweise ist die erste Kondensatorelektrode z.B. topfförmig. Ein Kondensatordielektrikum des Kondensators bedeckt mindestens den zweiten Teil der ersten Kondensatorelektrode und die inneren Flanken der ersten Kondensatorelektrode. Eine zweite Kondensatorelektrode des Kondensators grenzt an das Kondensatordielektrikum an.

Das Vorsehen der inneren Flanken der ersten Kondensatorelektrode bewirkt eine Erhöhung einer Kapazität des Kondensators ohne den Platzbedarf des Kondensators zu vergrößern.

Umfaßt die integrierte Schaltungsanordnung eine DRAM-Zellenanordnung, so ist das Vorsehen des Kondensators als Teil der Speicherzelle besonders vorteilhaft, da die Menge der auf der Gateelektrode des ersten Transistors gespeicherten Ladung vergrößert werden kann, mit der Folge, daß die Information der Speicherzelle über einen längeren Zeitraum gespeichert werden kann, bevor die Information aufgefrischt werden muß.

Eine Höhe des ersten Teils der ersten Kondensatorelektrode kann weniger als ca. 1000nm betragen. Da die Ladung auf dem Kondensator im Gegensatz zur Ladung auf einem Speicherkondensator einer DRAM-Zellenanordnung, bei der eine Speicherzelle einen Transistor und den Speicherkondensator umfaßt, das Signal an der Bitleitung nicht erzeugen, sondern lediglich den ersten Transistor im geöffneten Zustand halten muß, kann die Kapazität des Kondensators wesentlich geringer, z. B. fünf mal kleiner, sein als die Kapazität des Speicherkondensators. Die geringe Höhe der ersten Kondensatorelektrode ermöglicht es, daß die integrierte Schaltungsanordnung zusätzlich zur DRAM-Zellenanordnung eine Logikschaltung umfaßt, die ebenfalls im Substrat angeordnet ist. Es kann eine isolierende Schicht abgeschieden und planarisiert werden, die den Kondensator vollständig bedeckt. Der erste Transistor und der zweite Transistor können gleichzeitig mit Transistoren der Logikschaltung erzeugt werden.

Zur Erzeugung eines solchen Kondensators liegt es im Rahmen der Erfindung, über dem Substrat eine untere isolierende Schicht abzuscheiden und zu planarisieren. In der unteren Schicht wird eine Vertiefung erzeugt. Leitendes Material wird konform in einer solchen Dicke abgeschieden, daß die Vertiefung nicht gefüllt wird. Aus dem leitenden Material wird die erste Kondensatorelektrode erzeugt, indem lateral außerhalb der Vertiefung befindliches leitendes Material entfernt wird. Der erste Teil der ersten Kondensatorelektrode ist an Flanken der Vertiefung angeordnet.

Zur weiteren Erhöhung der Kapazität des Kondensators ohne zusätzlichen Platzbedarf ist es vorteilhaft, wenn das Kondensatordielektrikum zusätzlich mindestens Teile der äußeren Flanken der ersten Kondensatorelektrode bedeckt. Dazu wird beispielsweise nach Erzeugung der ersten Kondensatorelektrode ein Teil der unteren Schicht entfernt, so daß Teile der äußeren Flanken freigelegt werden.

Zur Erhöhung der Prozeßsicherheit ist es vorteilhaft, wenn über der unteren Schicht eine obere Schicht erzeugt wird, in der eine weitere Vertiefung erzeugt wird, die über der Vertiefung angeordnet ist. Das leitende Material der ersten Kondensatorelektrode wird nach Erzeugung der weiteren Vertiefung abgeschieden. Die erste Kondensatorelektrode wird erzeugt, indem das leitende Material außerhalb der Vertiefung und der weiteren Vertiefung entfernt wird. Nach Erzeugung der ersten Kondensatorelektrode wird die obere Schicht entfernt. Die untere Schicht kann dabei als Ätzstop wirken, so daß die Prozeßsicherheit erhöht wird, da ein Kurzschluß zwischen dem Substrat und der zweiten Kondensatorelektrode durch Abtragen der unteren Schicht vermieden wird. Ist die obere Schicht nicht selektiv zur unteren Schicht ätzbar, so liegt es im Rahmen der Erfindung, wenn zwischen der unteren Schicht und der oberen Schicht eine mittlere Schicht erzeugt wird, die als Ätzstop dient.

Die weitere Vertiefung kann zusammen mit der Vertiefung erzeugt werden. Alternativ wird die weitere Vertiefung nach Erzeugung der Vertiefung erzeugt.

Die Vertiefung, in der die erste Kondensatorelektrode angeordnet ist, kann mit der Vertiefung, in der die leitende Struktur der Diode angeordnet ist, zusammenfallen.

Zur Prozeßvereinfachung ist es vorteilhaft, wenn die erste Kondensatorelektrode mit der leitenden Struktur zusammenfällt. Darüber hinaus wird die Packungsdichte der integrierten Schaltungsanordnung erhöht, da der Kondensator über der Diode angeordnet ist und keinen zusätzlichen Platzbedarf erfordert.

Alternativ wird zunächst die leitende Struktur und anschließend die erste Kondensatorelektrode erzeugt. Dies bietet den Vorteil, daß die leitende Struktur und die erste Kondensatorelektrode aus unterschiedlichen Materialien bestehen können oder unterschiedliche Dotierstoffkonzentrationen aufweisen können. Elektrische Eigenschaften des Kondensators und der Diode können folglich unabhängig voneinander optimiert werden.

Die leitende Struktur besteht z. B. aus dotiertem Polysilizium, das eine Dotierstoffkonzentration zwischen ca. 10¹⁷ cm⁻³ und 10¹⁹ cm⁻³ aufweist. Die Dotierstoffkonzentration bestimmt die Strom-Spannungscharakteristik der Diode und wird dem jeweiligen Verwendungszweck der Speicherzelle angepaßt. Die erste Kondensatorelektrode besteht beispielsweise aus dotiertem Polysilizium, das eine möglichst hohe Dotierstoffkonzentration, z.B. ca. 10²⁰ cm⁻³, aufweist.

Es liegt im Rahmen der Erfindung, wenn zunächst die untere Schicht und die Vertiefung erzeugt werden, in der die leitende Struktur erzeugt wird. Anschließend können die obere Schicht, die weitere Vertiefung und der Kondensator erzeugt werden.

Das Kondensatordielektrikum kann SiO₂, Siliziumnitrid, ein Ferroelektrikum, wie Bariumstrontiumtitanat (BST), oder andere Materialien mit einer hohen Dielektrizitätskonstanten enthalten.

Die zweite Kondensatorelektrode kann z.B. dotiertes Polysilizium, silizidiertes Polysilizium und/oder ein Metall enthalten.

Im folgenden werden Ausführungsbeispiele der Erfindung anhand der Figuren näher erläutert.
- Figur 1: zeigt einen Querschnitt durch ein erstes Substrat, nachdem ein erster Transistor, ein zweiter Transistor, Transistoren einer Logikschaltung, eine untere Schicht und eine mittlere Schicht erzeugt wurden.
- Figur 2a: zeigt den Querschnitt aus Figur 1, nachdem eine Vertiefung, eine Diodenschicht, eine weitere Schicht und eine leitende Struktur erzeugt wurden.
- Figur 2b: zeigt eine Aufsicht auf das erste Substrat, in der die Transistoren und die leitende Struktur dargestellt sind.
- Figur 3: zeigt den Querschnitt aus Figur 2a, nachdem eine obere Schicht, eine weitere Vertiefung und eine erste Kondensatorelektrode erzeugt wurden.

- Figur 4: zeigt den Querschnitt aus Figur 3, nachdem ein Kondensatordielektrikum und eine zweite Kondensatorelektrode erzeugt wurden.
- Figur 5: zeigt einen Querschnitt durch ein zweites Substrat, nachdem zwei Transistoren, eine Diode und ein Kondensator erzeugt wurden.

Die Figuren sind nicht maßstabsgetreu.

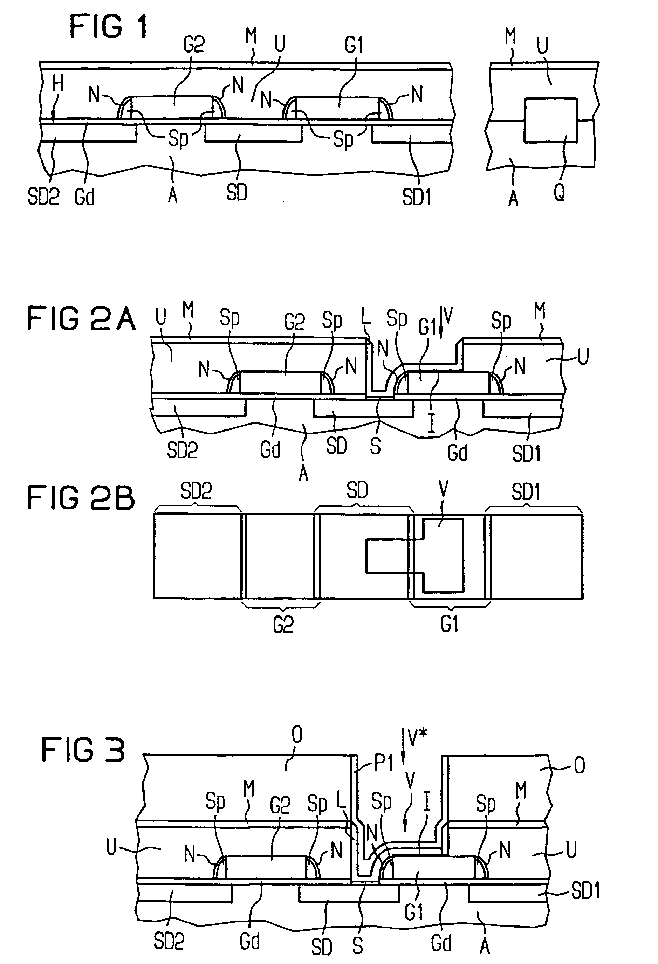

In einem ersten Ausführungsbeispiel werden in herkömmlicher Weise an einer Hauptfläche H eines p-dotierten ersten Substrats A aus Silizium ein planarer erster Transistor und ein planarer zweiter Transistor erzeugt. Ein erstes Source/Drain-Gebiet SD des ersten Transistors und ein erstes Source/Drain-Gebiet des zweiten Transistors werden als gemeinsames Source/Drain-Gebiet erzeugt (siehe Figur 1). Das erste Source/Drain-Gebiet SD des ersten Transistors, ein zweites Source/Drain-Gebiet SD1 des ersten Transistors und ein zweites Source/Drain-Gebiet SD2 des zweiten Transistors weisen eine Dotierstoffkonzentration von ca. 10²¹ cm⁻³ auf und sind n-dotiert. Das zweite Source/Drain-Gebiet SD1 des ersten Transistors ist streifenförmig und mit einem Spannungsanschluß verbunden. Eine Gateelektrode G1 des ersten Transistors und eine Gateelektrode G2 des zweiten Transistors sind über dem ersten Substrat A angeordnet und vom ersten Substrat A durch ein Gatedielektrikum Gd getrennt (siehe Figur 1). Die Gateelektroden G1, G2 weisen eine Dotierstoffkonzentration von ca. 10²⁰cm⁻³ auf. Die Gateelektrode G2 des zweiten Transistors ist Teil einer streifenförmigen Wortleitung. Gleichzeitig mit den zwei Transistoren werden Transistoren einer Logikschaltung Q, die schematisch in Figur 1 dargestellt ist, erzeugt.

Zur Erzeugung von Spacern Sp an Flanken der Gateelektroden G1, G2 der Transistoren wird SiO₂ in einer Dicke von ca. 50nm abgeschieden und rückgeätzt.

Die Spacer Sp werden mit einer Schicht N aus Siliziumnitrid versehen, indem Siliziumnitrid in einer Dicke von ca. 20nm abgeschieden und rückgeätzt wird, bis die Gateelektroden G1, G2 der Transistoren freigelegt werden (siehe Figur 1).

Zur Erzeugung einer isolierenden unteren Schicht U wird durch ein TEOS-Verfahren SiO₂ in einer Dicke von ca. 800 nm abgeschieden und durch chemisch-mechanisches Polieren planarisiert. Auf der unteren Schicht U wird eine mittlere Schicht M erzeugt, indem Siliziumnitrid in einer Dicke von ca. 50 nm abgeschieden wird (siehe Figur 1).

Mit Hilfe einer ersten Fotolackmaske (nicht dargestellt) wird Siliziumnitrid und SiO₂ geätzt, bis ein Teil des ersten Source/Drain-Gebiets SD des ersten Transistors, ein Teil der Schicht N aus Siliziumnitrid und ein Teil der Gateelektrode G1 des ersten Transistors freigelegt werden, so daß eine Vertiefung V erzeugt wird, dessen Boden an das erste Source/Drain-Gebiet SD des ersten Transistors und an die Gateelektrode G1 des ersten Transistors angrenzt (siehe Figur 2a). Eine Fläche des freigelegten Teils der Gateelektrode G1 des ersten Transistors ist etwa zwei mal größer als der freigelegte Teil des ersten Source/Drain-Gebiets SD des ersten Transistors (siehe Figur 2b).

Nach einer reduzierenden Reinigung mit z.B. Flußsäure wird eine thermische Oxidation durchgeführt. Dabei wird auf dem ersten Source/Drain-Gebiet SD des ersten Transistors eine Diodenschicht S aus SiO₂ erzeugt, die ca. 1,5 nm dick ist. Ferner wird auf der Gateelektrode G1 des ersten Transistors eine weitere Schicht I erzeugt (siehe Figur 2a).

Zur Erzeugung einer leitenden Struktur L wird in situ dotiertes Polysilizium in einer Dicke von ca. 70nm abgeschieden, so daß Flächen der Vertiefung V bedeckt werden, die Vertiefung V aber nicht gefüllt wird. Durch chemisch-mechanisches Polieren wird das leitende Material außerhalb der Vertiefung V entfernt, so daß in der Vertiefung V aus dem leitenden Material die leitende Struktur L erzeugt wird, die auf der Diodenschicht S der Diode und auf der weiteren Schicht I angeordnet ist (siehe Figuren 2a und 2b).

Die Dotierstoffkonzentration der leitenden Struktur L beträgt ca. 10²⁰cm⁻³. Das erste Source/Drain-Gebiet SD des ersten Transistors, die Diodenschicht S und die leitende Struktur L bilden eine Diode, die zwischen das erste Source/Drain-Gebiet SD des ersten Transistors und die Gateelektrode G1 des ersten Transistors geschaltet ist.

Ein elektrischer Widerstand der Diode ist für einen Stromfluß vom ersten Source/Drain-Gebiet SD des ersten Transistors zur Gateelektrode G1 des ersten Transistors besonders klein, da der Strom von hoch dotierten zu niedrig dotierten Gebieten durch die Diodenschicht S fließt. Diese Richtung des Stromflusses wird auch als Flußrichtung der Diode bezeichnet. Ein elektrischer Widerstand der Diode für einen Stromfluß von der Gateelektrode G1 des ersten Transistors zum ersten Source/Drain-Gebiet SD des ersten Transistors ist im Vergleich dazu besonders groß. Diese Richtung des Stromflusses wird auch als Sperrrichtung der Diode bezeichnet. Die Diode ist folglich so geschaltet, daß ein Abfließen von Ladung von der Gateelektrode G1 des ersten Transistors zum ersten Source/Drain-Gebiet SD des ersten Transistors erschwert wird.

Die Wirkung der weiteren Schicht I auf den Stromfluß durch die Diode ist im Vergleich zur Wirkung der Diodenschicht S vernachlässigbar. Ein Grund dafür ist, daß die Gateelektrode G1 des ersten Transistors aus Polysilizium besteht und folglich eine rauhere Oberfläche als das erste Source/Drain-Gebiet DS des ersten Transistors, das aus monokristallines Silizium besteht, aufweist. Die weitere Schicht I wächst auf der rauheren Oberfläche inhomogen, so daß die weitere Schicht I so beschaffen ist, daß hohe Leckströme durch sie fließen können. Ein weiterer Grund ist, daß eine Fläche der weiteren Schicht I etwa zwei mal größer ist als eine Fläche der Diodenschicht S.

Es wird eine obere Schicht O erzeugt, indem SiO₂ in einer Dicke von ca. 800 nm abgeschieden wird. Mit Hilfe einer zweiten Fotolackmaske (nicht dargestellt) wird in der oberen Schicht O eine weitere Vertiefung V* erzeugt, die oberhalb der Vertiefung V angeordnet ist. Dabei wird die leitende Struktur L freigelegt (siehe Figur 3).

Die Erzeugung der weiteren Vertiefung ist gegenüber einer Fehljustierung bezüglich der Vertiefung weitergehend tolerant, da selektiv zu Siliziumnitrid geätzt wird, so daß Teile der Gateelektroden G1, G2 der Transistoren und Teile des ersten Substrats A nicht freigelegt werden können. Die mittlere Schicht M wirkt als Ätzstop. Als Ätzmittel ist z. B. C₂F₆ geeignet.

Zur Erzeugung einer ersten Kondensatorelektrode P1 eines Kondensators wird in situ dotiertes Polysilizium in einer Dicke von ca. 50 nm abgeschieden und durch chemisch mechanisches Polieren planarisiert, so daß das Polysilizium außerhalb der Vertiefung V und der weiteren Vertiefung V* entfernt wird. Die erste Kondensatorelektrode P1 ist auf der leitenden Struktur L angeordnet.

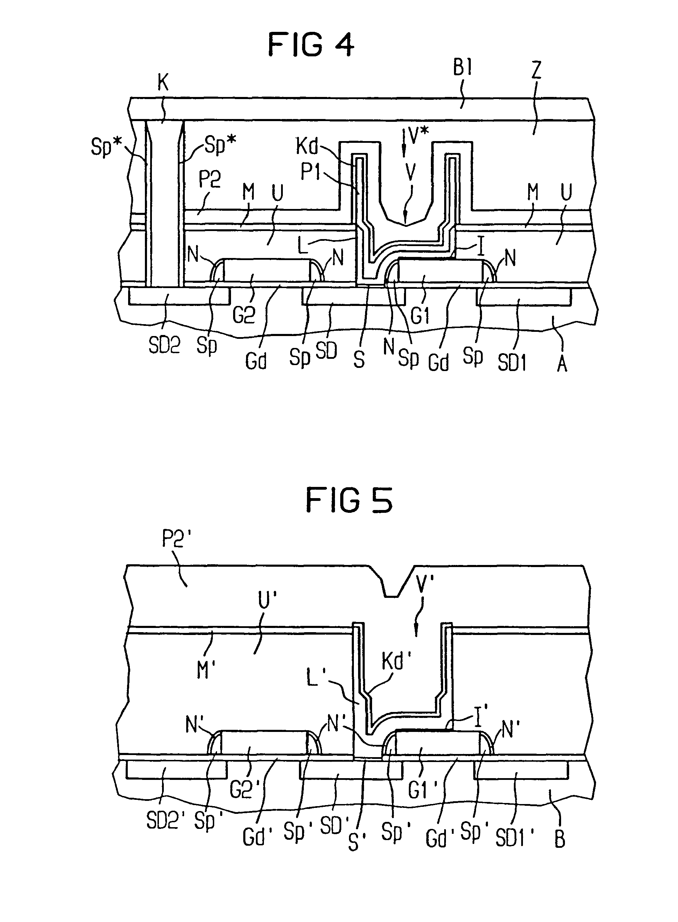

Anschließend wird die obere Schicht O durch Ätzen von SiO₂ selektiv zu Polysilizium und Siliziumnitrid entfernt, so daß Teile von äußeren, den Mitten der Vertiefungen V, V* abgewandten Flanken der ersten Kondensatorelektrode P1 freigelegt werden (siehe Figur 4).

An freiliegenden Flächen der ersten Kondensatorelektrode P1 wird ein Kondensatordielektrikum Kd erzeugt, indem Siliziumnitrid in einer Dicke von ca. 7nm abgeschieden und teilweise aufoxidiert wird (siehe Figur 4).

Zur Erzeugung einer zweiten Kondensatorelektrode P2 wird in situ dotiertes Polysilizium in einer Dicke von ca. 100 nm abgeschieden (siehe Figur 4). Die zweite Kondensatorelektrode P2 weist eine Dotierstoffkonzentration von ca. 10²⁰cm⁻³ auf.

Durch das vorstehend beschriebene Verfahren wird eine DRAM-Zellenanordnung erzeugt, bei dem eine Speicherzelle den ersten Transistor, den zweiten Transistor, die Diode und den Kondensator umfaßt. Es wird ein Zwischenoxid Z abgeschieden und planarisiert, das die Kondensatoren bedeckt. Im Zwischenoxid Z werden Kontaktlöcher geätzt, die die zweiten Source/Drain-Gebiete SD2 der zweiten Transistoren der Speicherzellen freilegen. Zur Erzeugung von weiteren Spacern Sp* an Flanken der Kontaktlöcher wird SiO₂ in einer Dicke von 25nm abgeschieden und rückgeätzt. Die Kontaktlöcher werden mit Wolfram gefüllt, so daß Kontakte K erzeugt werden, die durch die weiteren Spacer Sp* von der zweiten Kondensatorelektrode P2 getrennt sind. Auf dem Zwischenoxid werden die Bitleitungen B1 erzeugt, die an die Kontakte K angrenzen und quer zur Wortleitung verlaufen.

In einem zweiten Ausführungsbeispiel werden entsprechend dem ersten Ausführungsbeispiel ausgehend von einem zweiten Substrat B aus Silizium ein erstes Source/Drain-Gebiet SD' eines ersten Transistors, das zugleich als erstes Source/Drain-Gebiet eines zweiten Transistors wirkt, ein zweites Source/Drain-Gebiet SD1' des ersten Transistors, ein zweites Source/Drain-Gebiet SD2' des zweiten Transistors, eine Gateelektrode G1' des ersten Transistors, eine Gateelektrode G2' des zweiten Transistors, ein Gatedielektrikum GD', Spacer Sp', eine Schicht N' aus Siliziumnitrid, eine Diodenschicht S', eine weitere isolierende Schicht I', eine isolierende untere Schicht U', eine mittlere Schicht M', eine Vertiefung V' und eine leitende Struktur L' erzeugt (siehe Figur 5). Im Gegensatz zum ersten Ausführungsbeispiel ist jedoch die Dicke der unteren isolierenden Schicht U' ca. 1200 nm dick. Die leitende Struktur L' dient zugleich als erste Kondensatorelektrode eines Kondensators.

Entsprechend dem ersten Ausführungsbeispiel wird ein Kondensatordielektrikum Kd' erzeugt. Da die äußeren Flanken der ersten Kondensatorelektrode, d. h. der leitenden Struktur L', nicht freiliegen, wird das Kondensatordielektrikum Kd' nur an inneren, der Mitte der Vertiefung V' zugewandten Flanken der leitenden Struktur L' erzeugt (siehe Figur 5).

Wie im ersten Ausführungsbeispiel wird durch Abscheiden von in situ dotiertem Polysilizium eine zweite Kondensatorelektrode P2' erzeugt.

Wie im ersten Ausführungsbeispiel wird auch hier eine DRAM-Zellenanordnung erzeugt, bei dem eine Speicherzelle den ersten Transistor, den zweiten Transistor, die Diode und den Kondensator umfaßt.

Es sind viele Variationen der Ausführungsbeispiele denkbar, die ebenfalls im Rahmen der Erfindung liegen. So können Abmessungen der Schichten, Strukturen, Vertiefungen und Gebiete an die jeweiligen Erfordernisse angepaßt werden. Dasselbe gilt für die Dotierstoffkonzentration und für die Wahl von Materialien.

Die Source/Drain-Gebiete können p-dotiert, und die Substrate können n-dotiert sein.

Auf die Erzeugung der Kondensatoren kann verzichtet werden.

Eine andere Möglichkeit die ersten Source/Drain-Gebiete mit dem Spannungsanschluß zu verbinden, besteht darin, nach Erzeugung der zweiten Kondensatorelektrode ein erstes Zwischenoxid zu erzeugen, in das Kontaktlöcher zu den zweiten Source/Drain-Gebieten der ersten Transistoren erzeugt werden. Die Kontaktlöcher werden mit isolierenden Spacern versehen und mit Wolfram gefüllt, so daß Kontakte erzeugt werden. Auf dem Zwischenoxid werden durch Abscheiden und Strukturierung von leitendem Material Metallbahnen erzeugt, die die Kontakte mit dem Spannungsanschluß verbinden. Anschließend wird ein weiteres Zwischenoxid erzeugt, in das die Kontaktlöcher für die Bitleitungen erzeugt werden. Wie oben beschrieben, werden Kontakte und die Bitleitungen erzeugt.

## Patentansprüche

1. Integrierte Schaltungsanordnung,
- mit einem planaren ersten Transistor, dessen erstes Source/Drain-Gebiet (SD) und dessen zweites Source/Drain-Gebiet (SD1) (in einem Substrat (A) angeordnet sind und an eine Hauptfläche (H) des Substrats (A) angrenzen, und dessen Gateelektrode (G1) über dem Substrat (A) angeordnet ist,
- mit einer Diode, die zwischen das erste Source/Drain-Gebiet (SD) und die Gateleketrode (G1) so geschaltet ist, dass ein Abfließen von Ladung von der Gateelektrode (G1) zum ersten Source/Drain-Gebiet (SD) erschwert wird,
- bei der eine Diodenschicht (S), die Teil der Diode ist, auf mindestens einem Teil des ersten Source/Drain-Gebiets (SD) angeordnet ist,
und
- bei der eine leitende Struktur (L), die ein weiterer Teil der Diode ist, über mindestens einem Teil der Gateeleketrode (G1) und auf der Diodenschicht (S) angeordnet ist,
**dadurch gekennzeichnet, dass**
- die Diodenschicht (S) isolierendes Material enthält, und
- die Dicke der Diodenschicht (S) so bemessen ist, dass ein Strom durch die Diodenschicht (S) im Wesentlichen auf Grund von Tunneln von Elektronen durch die Diodenschicht (S) entsteht.

2. Integrierte Schaltungsanordnung nach Anspruch 1, **dadurch gekennzeichnet, dass**
- eine weitere Schicht (I) zwischen der Gateelektrode (G1) und der leitenden Struktur (L) angeordnet ist, und
- das erste Source/Drain-Gebiet (SD), die Diodenschicht (S), die leitende Struktur (L), die weitere Schicht (I) und die Gateelektrode (G1) so beschaffen sind, dass elektrische Widerstände der Diode wesentlich größer sind als elektrische Widerstände, die durch die Gateelektrode (G1), die weitere Schicht (I) und die leitende Struktur (L) gebildet werden.

3. Integrierte Schaltungsanordnung nach Anspruch 1 oder 2,
**dadurch gekennzeichnet, dass**
- eine zur Hauptfläche (H) im Wesentlichen parallele Fläche der weiteren Schicht (I) mehr als zwei mal größer ist als eine zur Hauptfläche (H) im Wesentlichen parallele Fläche der Diodenschicht (S).

4. Integrierte Schaltungsanordnung nach einem der Ansprüche 1 bis 3,
**dadurch gekennzeichnet, dass**
- ein Kondensator über dem Substrat (A) angeordnet ist, dessen erste Kondensatorelektrode (P1) mit der leitenden Struktur (L) elektrisch verbunden ist,
- ein erster Teil der ersten Kondensatorelektrode (P1) auf einem Rand einer Projektion der ersten Kondensatorelektrode (P1) auf die Hauptfläche (H) des Substrats (A) angeordnet ist und bis zu einer Höhe reicht, die größer ist als eine Höhe, bis zu der ein zweiter Teil der ersten Kondensatorelektrode (P1) reicht, der auf übrigen Teilen der Projektion angeordnet ist, sodass die erste Kondensatorelektrode (P1) innere Flanken und äußere, der Projektion abgewandte Flanken aufweist,
- ein Kondensatordielektrikum (Kd) des Kondensators mindestens den zweiten Teil der ersten Kondensatorelektrode (P1) und die inneren Flanken der ersten Kondensatorelektrode (P1) bedeckt, und eine zweite Kondensatorelektrode (P2) des Kondensators an das Kondensatordielektrikum (Kd) angrenzt.

5. Integrierte Schaltungsanordnung nach Anspruch 4,
**dadurch gekennzeichnet, dass**
- das Kondensatordielektrikum (Kd) mindestens Teile der äußeren Flanken der ersten Kondensatorelektrode (P1) bedeckt.

6. Integrierte Schaltungsanordnung nach Anspruch 4 oder 5,
**dadurch gekennzeichnet, dass**
- die leitende Struktur (L') mit der ersten Kondensatorelektrode (P1) zusammenfällt.

7. Integrierte Schaltungsanordnung nach Anspruch 4 oder 5,
**dadurch gekennzeichnet, dass**
- eine Projektion der leitenden Struktur (L) auf die Hauptfläche (H) mit der Projektion der ersten Kondensatorelektrode (P1) zusammenfällt,
- ein erster Teil der leitenden Struktur (L) auf einem Rand der Projektion der leitenden Struktur (L) angeordnet ist und bis zu einer Höhe reicht, die größer ist als eine Höhe, bis zu der ein zweiter Teil der leitenden Struktur (L) reicht, der auf den übrigen Teilen der Projektion angeordnet ist, und
- der erste Teil der ersten Kondensatorelektrode (P1) auf dem ersten Teil der leitenden Struktur (L) angeordnet ist.

8. Integrierte Schaltungsanordnung nach einem der Ansprüche 1 bis 7,
**dadurch gekennzeichnet, dass**
- eine Speicherzelle den ersten Transistor, die Diode und einen zweiten Transistor umfasst,
- das erste Source/Drain-Gebiet (SD) des ersten Transistors und ein erstes Source/Drain-Gebiet des zweiten Transistors miteinander verbunden sind,
- der erste Transistor und der zweite Transistor zwischen einen Spannungsanschluss und eine Bitleitung (B1) geschaltet sind,
- eine Gateelektrode (G2) des zweiten Transistors mit einer Wortleitung verbunden ist, und
- die Speicherzelle Teil einer DRAM-Zellenanordnung ist, die mindestens ein Teil der integrierten Schaltungsanordnung ist.

9. Integrierte Schaltungsanordnung nach Anspruch 8,
**dadurch gekennzeichnet, dass**
- das Substrat (A) eine Logikschaltung (Q) umfasst.

10. Verfahren zur Herstellung einer integrierten Schaltungsanordnung,
- bei dem durch maskierte Implantation eines Substrats (A) ein erstes Source/Drain-Gebiet (SD) und ein zweites Source/Drain-Gebiet (SD1) eines planaren ersten Transistors erzeugt werden, sodass sie an eine Hauptfläche (H) des Substrats (A) angrenzen,
- bei dem über dem Substrat (A) eine Gatelektrode (G1) des ersten Transistors erzeugt wird,
- bei dem eine Diodenschicht (S), die Teil einer Diode ist, auf mindestens einem Teil des ersten Source/Drain-Gebiets (SD) erzeugt wird,
- bei dem eine leitende Struktur (L) erzeugt wird, die ein weiterer Teil der Diode ist und über mindestens einem Teil der Gateleketrode (G1) und über der Diodenschicht (S) angeordnet ist, und
- bei dem die Diode so erzeugt wird, dass ein Abfließen von Ladung von der Gateelektrode (G1) zum ersten Source/Drain-Gebiet (SD) erschwert wird,
**dadurch gekennzeichnet, dass**
- die Diodenschicht (S) aus isolierendem Material erzeugt wird, und
- die Diodenschicht (S) in einer solchen Dicke erzeugt wird, dass ein Strom durch die Diodenschicht (S) im Wesentlichen auf Grund von Tunneln von Elektronen durch die Diodenschicht (S) entsteht.

11. Verfahren nach Anspruch 10,
**dadurch gekennzeichnet, dass**
- das Substrat (A) mindestens im Bereich des ersten Source/Drain-Gebiets (SD) monokristallines Silizium enthält,
- die Gateelektrode (G1) aus dotiertem Polysilizium erzeugt wird,
- die Diodenschicht (S) durch thermische Oxidation erzeugt wird,
- durch die thermische Oxidation eine weitere Schicht (I) auf der Gateelektrode (G1) erzeugt wird, und
- die leitende Struktur (L) auch auf der weiteren Schicht (I) erzeugt wird.

12. Verfahren nach Anspruch 10 oder 11,
**dadurch gekennzeichnet, dass**
- die leitende Struktur (L) so erzeugt wird, dass sie eine zur Hauptfläche (H) im Wesentlichen parallele Fläche der weiteren Schicht (I) bedeckt, die mehr als zwei mal größer ist als eine von der leitenden Struktur (L) bedeckte, zur Hauptfläche (H) im Wesentlichen parallele Fläche der Diodenschicht (S).

13. Verfahren nach einem der Ansprüche 10 bis 12
**dadurch gekennzeichnet, dass**
- über dem Substrat (A) eine isolierende untere Schicht (U) abgeschieden und planarisiert wird,
- in der unteren Schicht (U) eine Vertiefung (V) erzeugt wird,
- leitendes Material konform in einer solchen Dicke abgeschieden wird, dass die Vertiefung (V) nicht gefüllt wird,
- aus dem leitenden Material eine erste Kondensatorelektrode (P1) eines Kondensators erzeugt wird, indem leitendes Material lateral außerhalb der Vertiefung (V) entfernt wird,
- die erste Kondensatorelektrode (P1) mit der leitenden Struktur (L) elektrisch verbunden wird,
- ein Kondensatordielektrikum (Kd) des Kondensators erzeugt wird, das freiliegende Teile der ersten Kondensatorelektrode (P1) bedeckt, und
- eine zweite Kondensatorelektrode (P2) des Kondensators erzeugt wird, die das Kondensatordielektrikum (Kd) bedeckt.

14. Verfahren nach Anspruch 13,
**dadurch gekennzeichnet, dass**
- über der unteren Schicht (U) eine obere Schicht (0) erzeugt wird,
- in der oberen Schicht (O) eine weitere Vertiefung (V*) erzeugt wird, die über der Vertiefung (V*) in der unteren Schicht (U) angeordnet ist,
- das leitende Material der ersten Kondensatorelektrode (P1) nach Erzeugung der weiteren Vertiefung (V*) abgeschieden wird,
- die erste Kondensatorelektrode (P1) erzeugt wird, indem das leitende Material außerhalb der Vertiefung (V) und der weiteren Vertiefung (V*) entfernt wird, und
- nach Erzeugung der ersten Kondensatorelektrode (P1) die obere Schicht (O) entfernt wird.

15. Verfahren nach Anspruch 13 oder 14,
**dadurch gekennzeichnet, dass**
- die Vertiefung (V) so erzeugt wird, dass das untere Source/Drain-Gebiet (SD) und die Gateelektrode (G1) teilweise freigelegt werden, und
- danach die thermische Oxidation zur Erzeugung der Diodenschicht (S) und der weiteren Schicht (I) durchgeführt wird.

16. Verfahren nach einem der Ansprüche 13 bis 15,
**dadurch gekennzeichnet, dass**
- durch die Erzeugung der ersten Kondensatorelektrode die leitende Struktur (L') erzeugt wird, die mit der ersten Kondensatorelektrode zusammenfällt.

17. Verfahren nach einem der Ansprüche 13 bis 15,
**dadurch gekennzeichnet, dass**
- nach Erzeugung der Vertiefung (V) in der unteren Schicht (U) leitendes Material konform abgeschieden und außerhalb der Vertiefung (V) entfernt wird, sodass aus dem leitenden Material die leitende Struktur (L) erzeugt wird,
- danach die obere Schicht (O) und die weitere Vertiefung (V*) erzeugt werden, und
- die erste Kondensatorelektrode (P1) erzeugt wird, indem leitendes Material abgeschieden und außerhalb der Vertiefung (V) und der weiteren Vertiefung (V*) entfernt wird.

18. Verfahren nach einem der Ansprüche 10 bis 17,
**dadurch gekennzeichnet, dass**
- eine Speicherzelle erzeugt wird, die mindestens den ersten Transistor, die Diode und einen zweiten Transistor umfasst,
- das erste Source/Drain-Gebiet (SD) des ersten Transistors und ein erstes Source/Drain-Gebiet des zweiten Transistors elektrisch miteinander verbunden werden,
- ein Spannungsanschluss und eine Bitleitung (B1) erzeugt werden, zwischen die der erste Transistor und der zweite Transistor geschaltet werden,
- eine Wortleitung erzeugt wird, die mit einer Gateelektrode (G2) des zweiten Transistors elektrisch verbunden wird, und
- mehrere Speicherzellen, die entsprechend der Speicherzelle gestaltet sind, erzeugt werden, sodass sie eine DRAM-Zellenanordnung bilden, die mindestens ein Teil der integrierten Schaltungsanordnung ist.

19. Verfahren nach Anspruch 18,
**dadurch gekennzeichnet, dass**
- im Substrat (A) eine Logikschaltung (Q) erzeugt wird, sodass die integrierte Schaltungsanordnung mindestens die DRAM-Zellenanordnung und die Logikschaltung (Q) umfasst.

## Claims

1. Integrated circuit arrangement
- having a planar first transistor whose first source/drain region (SD) and whose second source/drain region (SD1) are arranged in a substrate (A) and adjoin a main surface (H) of the substrate (A), and whose gate electrode (G1) is arranged over the substrate (A),
- having a diode which is connected between the first source/drain region (SD) and the gate electrode (G1) in such a way that it is made more difficult for charge to flow away from the gate electrode (G1) to the first source/drain region (SD),
- in which a diode layer (S), which is part of the diode, is arranged on at least part of the first source/drain region (SD),
and
- in which a conductive structure (L), which is a further part of the diode, is arranged over at least part of the gate electrode (G1) and on the diode layer (S),
**characterized in that**
- the diode layer (S) contains insulating material, and
- the thickness of the diode layer (S) is dimensioned in such a way that a current through the diode layer (S) is produced, essentially owing to tunneling of electrodes through the diode layer (S).

2. Integrated circuit arrangement according to Claim 1, **characterized in that**
- a further layer (I) is arranged between the gate electrode (G1) and the conductive structure (L), and
- the first source/drain region (SD), the diode layer (S), the conductive structure (L), the further layer (I) and the gate electrode (G1) are produced in such a way that electrical resistances of the diode are significantly greater than electrical resistances which are formed by the gate electrode (G1), the further layer (I) and the conductive structure (L).

3. Integrated circuit arrangement according to Claim 1 or 2, **characterized in that**
- a surface of the further layer (I) which is essentially parallel to the main surface (H) is more than twice as large as a surface of the diode layer (S) which is essentially parallel to the main surface (H).

4. Integrated circuit arrangement according to one of Claims 1 to 3, **characterized in that**
- arranged over the substrate (A) is a capacitor whose first capacitor electrode (P1) is electrically connected to the conductive structure (L),
- a first part of the first capacitor electrode (P1) is arranged on an edge of a projection of the first capacitor electrode (P1) onto the main surface (H) of the substrate (A) and extends to a height which is greater than a height up to which a second part of the first capacitor electrode (P1) extends, said second part being arranged on other parts of the projection so that the first capacitor electrode (P1) has inner edges and outer edges facing away from the projection,
- a capacitor dielectric (Kd) of the capacitor covers at least the second part of the first capacitor electrode (P1) and the inner edges of the first capacitor electrode (P1), and a second capacitor electrode (P2) of the capacitor adjoins the capacitor dielectric (Kd).

5. Integrated circuit arrangement according to Claim 4, **characterized in that**
- the capacitor dielectric (Kd) covers at least parts of the outer edges of the first capacitor electrode (P1).

6. Integrated circuit arrangement according to Claim 4 or 5, **characterized in that**
- the conductive structure (L') coincides with the first capacitor electrode (P1).

7. Integrated circuit arrangement according to Claim 4 or 5, **characterized in that**
- a projection of the conductive structure (L) onto the main surface (H) coincides with the projection of the first capacitor electrode (P1),
- a first part of the conductive structure (L) is arranged on an edge of the projection of the conductive structure (L) and extends to a height which is greater than a height to which a second part of the conductive structure (L) extends, said second part being arranged on the other parts of the projection; and
- the first part of the first capacitor electrode (P1) being arranged on the first part of the conductive structure (L).

8. Integrated circuit arrangement according to one of Claims 1 to 7, **characterized in that**
- a memory cell comprises the first transistor, the diode and a second transistor,
- the first source/drain region (SD) of the first transistor and a first source/drain region of the second transistor are connected to one another,
- the first transistor and the second transistor are connected between a voltage terminal and a bit line (B1),
- a gate electrode (G2) of the second transistor is connected to a word line, and
- the memory cell is part of a DRAM cell arrangement which is at least part of the integrated circuit arrangement.

9. Integrated circuit arrangement according to Claim 8, **characterized in that**
- the substrate (A) comprises a logic circuit (Q).

10. Method for manufacturing an integrated circuit arrangement,
- in which a first source/drain region (SD) and a second source/drain region (SD1) of a planar first transistor are generated by masked implantation of a substrate (A), in such a way that they adjoin a main surface (H) of the substrate (A),
- in which a gate electrode (G1) of the first transistor is generated over the substrate (A),
- in which a diode layer (S), which is part of a diode, is generated on at least part of the first source/drain region (SD),
- in which a conductive structure (L) is generated which is a further part of the diode and is arranged over at least part of the gate electrode (G1) and over the diode layer (S), and
- in which the diode is generated in such a way that it is made more difficult for charge to flow away from the gate electrode (G1) to the first source/drain region (SD),
**characterized in that**
- the diode layer (S) is generated from insulating material, and
- the diode layer (S) is generated to such a thickness that a current through the diode layer (S) is produced essentially owing to tunneling of electrodes through the diode layer (S).

11. Method according to Claim 10, **characterized in that**
- the substrate (A) contains monocrystalline silicon at least in the vicinity of the first source/drain region (SD),
- the gate electrode (G1) is generated from doped polysilicon,
- the diode layer (S) is generated by means of thermal oxidation,
- a further layer (I) is generated on the gate electrode (G1) by means of the thermal oxidation, and
- the conductive layer (L) is also generated on the further layer (I).

12. Method according to Claim 10 or 11, **characterized in that**
- the conductive structure (L) is generated in such a way that it covers a surface of the further layer (I) which is essentially parallel to the main surface (H) and which is more than twice as large as a surface of the diode layer (S) which is covered by the conductive structure (L) and is essentially parallel to the main surface (H).

13. Method according to one of Claims 10 to 12, **characterized in that**
- an insulating lower layer (U) is deposited over the substrate (A) and planarized,
- a depression (V) is generated in the lower layer (U),
- conductive material is deposited conformly to such a thickness that the depression (V) is not filled,
- a first capacitor electrode (P1) of a capacitor is generated from the conductive material by removing conductive material laterally outside the depression (V),
- the first capacitor electrode (P1) is electrically connected to the conductive structure (L),
- a capacitor dielectric (Kd) of the capacitor which covers exposed parts of the first capacitor electrode (P1) is generated, and
- a second capacitor electrode (P2) of the capacitor which covers the capacitor dielectric (Kd) is generated.

14. Method according to Claim 13, **characterized in that**
- an upper layer (O) is generated over the lower layer (U),
- a further depression (V*), which is arranged over the depression (V*) in the lower layer (U), is generated in the upper layer (O),
- the conductive material of the first capacitor electrode (P1) is deposited after the further depression (V*) is generated,
- the first capacitor electrode (P1) is generated by removing the conductive material outside the depression (V) and the further depression (V*), and
- after the first capacitor electrode (P1) is generated, the upper layer (O) is removed.

15. Method according to Claim 13 or 14, **characterized in that**
- the depression (V) is generated in such a way that the lower source/drain region (SD) and the gate electrode (G1) are partially exposed, and
- the thermal oxidation is then carried out in order to generate the diode layer (S) and the further layer (I).

16. Method according to one of Claims 13 to 15, **characterized in that**
- the conductive structure (L') which coincides with the first capacitor electrode is generated by generating the first capacitor electrode.

17. Method according to one of Claim 13 to 15, **characterized in that**
- in the lower layer (U), conductive material is deposited conformly after the depression (V) is generated and is removed outside the depression (V) so that the conductive structure (L) is generated from the conductive material,
- the upper layer (O) and the further depression (V*) are then generated, and
- the first capacitor electrode (P1) is generated by depositing conductive material and removing it outside the depression (V) and the further depression (V*).

18. Method according to one of Claims 10 to 17, **characterized in that**
- a memory cell is generated which comprises at least the first transistor, the diode and a second transistor,
- the first source/drain region (SD) of the first transistor and a first source/drain region of the second transistor are electrically connected to one another,
- a voltage terminal and a bit line (B1), between which the first transistor and the second transistor are connected, are generated,
- a word line is generated which is electrically connected to a gate electrode (G2) of the second transistor, and
- a plurality of memory cells which are designed so as to correspond to the memory cell are generated, so that they form a DRAM cell arrangement which is at least part of the integrated circuit arrangement.

19. Method according to Claim 18, **characterized in that**
- a logic circuit (Q) is generated in the substrate (A) so that the integrated circuit arrangement comprises at least the DRAM cell arrangement and the logic circuit (Q).

## Revendications

1. Circuit intégré,
- comprenant un premier transistor planaire dont la première zone (SD) de source/drain et dont la deuxième zone (SD1) de source/drain sont disposées dans un substrat et sont adjacentes à une surface (H) principale du substrat (A) et dont l'électrode (G1) de grille est disposée au-dessus du substrat (A) ;
- comprenant une diode qui est montée entre la première zone (SD)de source/drain et l'électrode (G1) de grille de façon à ce qu'une évacuation de charge de l'électrode (G1) de grille à la première zone (SD) de source/drain soit rendue difficile ;
- dans lequel une couche (S) de diode qui fait partie de la diode est disposée sur au moins une partie de la première zone (SD) de source/drain ;
et
- dans lequel une structure (L) conductrice qui représente une autre partie de la diode est disposée au-dessus d'au moins une partie de l'électrode (G1) de grille et sur la couche (S) de diode ;
**caractérisé en ce que**
- la couche (S) de diode contient de la matière isolante ; et
- l'épaisseur de la couche (S) de diode est telle qu'un courant passant à travers la couche (S) de diode se crée essentiellement sur la base de passage par effet tunnel d'électrons à travers la couche (S) de diode.

2. Circuit intégré suivant la revendication 1,
**caractérisé en ce que**
- une autre couche (I) est disposée entre l'électrode (G1) de grille et la structure (L) conductrice ; et
- la première zone (SD) de source/drain, la couche (S) de diode, la structure (L) conductrice, l'autre couche (I) et l'électrode (G1) de grille sont telles que des résistances électriques des diodes sont sensiblement plus grandes que des résistances électriques qui sont formées par l'électrode (G1) de grille, l'autre couche (I) et la structure (L) conductrice.

3. Circuit intégré suivant la revendication 1 ou 2, **caractérisé en ce que**
- une surface, sensiblement parallèle à la surface (H) principale, de l'autre couche (I) est plus de deux fois plus grande qu'une surface, sensiblement parallèle à la surface (H) principale, de la couche (S) de diode.

4. Circuit intégré suivant l'une des revendications 1 à 3,
**caractérisé en ce que**
- il est monté au-dessus du substrat (1) un condensateur dont la première électrode (P1) de condensateur est reliée électriquement à la structure (L) conductrice ;
- une première partie de la première électrode (P1) de condensateur est disposée sur un bord d'une projection de la première électrode (P1) de condensateur sur la surface (H) principale du substrat (A) et va jusqu'à un niveau qui est plus grand qu'un niveau jusqu'auquel va une deuxième partie de la première électrode (P1) de condensateur, deuxième partie qui est disposée sur d'autres parties de la projection, de sorte que la première électrode (P1) de condensateur a des flancs intérieurs et des flancs extérieurs éloignés de la projection ;
- un diélectrique (Kd) du condensateur recouvre au moins la deuxième partie de la première électrode (P1) de condensateur et les flancs intérieurs de la première électrode (P1) de condensateur ; et
- une deuxième électrode (P2) du condensateur est adjacente au diélectrique (Kd) de condensateur.

5. Circuit intégré suivant la revendication 4,
**caractérisé en ce que**
- le diélectrique (Kd) de condensateur recouvre au moins des parties des flancs extérieurs de la première électrode (P1) de condensateur.

6. Circuit intégré suivant la revendication 4 ou 5,
**caractérisé en ce que**
- la structure (L') conductrice coïncide avec la première électrode (P1) de condensateur.

7. Circuit intégré suivant la revendication 4 ou 5,
**caractérisé en ce que**
- une projection de la structure (L) conductrice sur la surface (H) principale coïncide avec la projection de la première électrode (P1) de condensateur ;
- une première partie de la structure (L) conductrice est disposée sur un bord de la projection de la structure (L) conductrice et va jusqu'à un niveau qui est plus haut qu'un niveau jusqu'auquel va une deuxième partie de la structure (L) conductrice, deuxième niveau qui est disposé sur les autres parties de la projection ; et
- la première partie de la première électrode (P1) de condensateur est disposée sur la première partie de la structure (L) conductrice.

8. Circuit intégré suivant l'une des revendications 1 à 7,
**caractérisé en ce que**
- une cellule de mémoire du premier transistor comprend la diode et un deuxième transistor ;
- la première zone (SD) de source/drain du premier transistor et une première zone de source/drain du deuxième transistor sont reliées entre elles ;
- le premier transistor et le deuxième transistor sont montés entre une borne de tension et une ligne (B1) de bits ;
- une électrode (G2) de grille du deuxième transistor est reliée à une ligne de mots ; et
- la cellule de mémoire fait partie d'un dispositif de cellules DRAM qui fait au moins partie du circuit intégré.

9. Circuit intégré suivant la revendication 8,
**caractérisé en ce que**
- le substrat (A) comprend un circuit (Q) logique.

10. Procédé de production d'un circuit intégré
- dans lequel on produit par implantation masquée d'un substrat (A) une première zone (SD) de source/drain et une deuxième zone (SD1) de source/drain d'un premier transistor planaire de manière à ce qu'il soit adjacent à une surface (H) principale du substrat (A) ;
- dans lequel on produit au-dessus du substrat (A) une électrode (G1) de grille du premier transistor ;
- dans lequel on produit une couche (S) de diode qui fait partie d'une diode sur au moins une partie de la première zone (SD) de source/drain ;
- dans lequel on produit une structure (L) conductrice qui constitue une autre partie de la diode et qui est disposée au-dessus d'au moins une partie de l'électrode (G1) de grille et au-dessus de la couche (S) de diode ; et
- dans lequel on produit la diode de façon à rendre plus difficile un écoulement de charge de l'électrode (G) de grille à la première zone (SD) de source/drain,
**caractérisé en ce que**
- on produit la couche (S) de diode en matière isolante ; et
- on produit la couche (S) de diode en une épaisseur telle qu'il se forme un courant passant à travers la couche (S) de diode sensiblement en raison de passage par effet tunnel d'électrons à travers la couche (S) de diode.

11. Procédé suivant la revendication 10,
**caractérisé en ce que**
- le substrat (A) contient au moins dans la partie de la première zone (SD) de source/drain du silicium monocristallin ;
- l'électrode (G1) de grille est produite en polysilicium dopé ;
- la couche (S) de diode est produite par oxydation thermique ;
- on produit par l'oxydation thermique une autre couche (I) sur l'électrode (G1) de grille ; et
- on produit la structure (L) conductrice également sur l'autre couche (I).

12. Procédé suivant la revendication 10 ou 11,
**caractérisé en ce que**
- on produit la structure (L) conductrice de façon à ce qu'elle recouvre une surface, sensiblement parallèle à la surface (H) principale, de l'autre couche qui est plus de deux fois plus grande qu'une surface, recouverte par la structure (L) conductrice et sensiblement parallèle à la surface (H) principale, de la couche (S) de diode.

13. Procédé suivant l'une des revendications 10 à 12,
**caractérisé en ce que**
- l'on dépose et on planarise au-dessus du substrat (A) une couche (U) inférieure isolante ;
- on produit dans la couche (U) inférieure une cavité (V) ;
- on dépose de la matière conductrice de façon conforme en une épaisseur telle que la cavité (V) ne soit pas remplie ;
- on produit en la matière conductrice une première électrode (P1) d'un condensateur en éliminant de la matière conductrice latéralement hors de la cavité (V) ;
- on relie électriquement la première électrode (P1) de condensateur à la structure (L) conductrice ;
- on produit un diélectrique (Kd) du condensateur qui recouvre des parties mises à nu de la première électrode (P1) de condensateur ; et
- on produit une deuxième électrode (P2) du condensateur qui recouvre le diélectrique (Kd) du condensateur.

14. Procédé suivant la revendication 13,
**caractérisé en ce que**
- on produit au-dessus de la couche (U) inférieure une couche (O) supérieure ;
- on produit dans la couche (O) supérieure une autre cavité (V*) qui est disposée au-dessus de la cavité (V*) de la couche (U) inférieure ;
- on dépose de la matière conductrice de la première électrode (P1) de condensateur après la production de l'autre cavité (V*) ;
- on produit la première électrode (P1) de condensateur en éliminant de la matière conductrice hors de la cavité (V) et de l'autre cavité (V*) ; et
- après production de la première électrode (P1) de condensateur, on élimine la couche (O) supérieure.

15. Procédé suivant la revendication 13 ou 14,
**caractérisé en ce que**
- on produit la cavité (V) de façon à ce que la zone (SD) de source/drain et l'électrode (G1) de grille soient mises à nu en partie ;et
- on effectue ensuite l'oxydation thermique pour la production de la couche (S) de diode et de l'autre couche (I).

16. Procédé suivant l'une des revendications 13 à 15,
**caractérisé en ce que**
- par la production de la première électrode de condensateur, on produit la structure (L') conductrice qui coïncide avec la première électrode de condensateur.

17. Procédé suivant l'une des revendications 13 à 15,
**caractérisé en ce que**
- après production de la cavité (V) dans la couche (U) inférieure isolante, on dépose de manière conforme de la matière conductrice et on l'élimine hors de la cavité (V) de manière à produire la structure (L) conductrice en la matière conductrice ;
- on produit ensuite la couche (O) supérieure et l'autre cavité (V*) ; et
- on produit la première électrode (P1) de condensateur en déposant de la matière conductrice et en l'éliminant hors de la cavité (V) et de l'autre cavité (V*).

18. Procédé suivant l'une des revendications 10 à 17,
**caractérisé en ce que**
- on produit une cellule de mémoire qui comprend au moins un premier transistor, la diode et un deuxième transistor ;
- on relie électriquement entre la première zone (SD) de source/drain du premier transistor et une première zone de source/drain du deuxième transistor ;
- on produit une borne de tension et une ligne (B1) de bits entre lesquelles le premier transistor et le deuxième transistor sont montés ;
- on produit une ligne de mots qui est reliée électriquement à une électrode (G2) de grille du deuxième transistor ; et
- on produit plusieurs cellules de mémoire qui sont conformées conformément à la cellule de mémoire, de sorte qu'elles forment un dispositif de cellules DRAM qui constitue au moins une partie du circuit intégré.

19. Procédé suivant la revendication 18,
**caractérisé en ce que**
- on produit dans le substrat (A) un circuit (Q) logique, de sorte que le circuit intégré comprend au moins le dispositif de cellules DRAM et le circuit (Q) logique.
